Europäisches Patentamt

European Patent Office

Office européen des brevets

(11) Veröffentlichungsnummer: **0 254 082**
**B1**

(12) **EUROPÄISCHE PATENTSCHRIFT**

(45) Veröffentlichungstag der Patentschrift:
08.08.90

(51) Int. Cl.⁵: **H05K 3/00**, H05K 3/42

(21) Anmeldenummer: 87109368.8

(22) Anmeldetag: 30.06.87

(54) Mehrlagige, starre und flexible Bereiche aufweisende Leiterplatte.

(30) Priorität: 22.07.86 DE 3624718

(43) Veröffentlichungstag der Anmeldung:
27.01.88 Patentblatt 88/4

(45) Bekanntmachung des Hinweises auf die Patenterteilung:
08.08.90 Patentblatt 90/32

(84) Benannte Vertragsstaaten:
AT BE CH DE FR GB IT LI NL SE

(56) Entgegenhaltungen:
EP-A- 0 147 566
GB-A- 2 065 381
US-A- 3 346 415
US-A- 4 687 695

(73) Patentinhaber: Schoeller & Co. Elektronik GmbH,
Marburger Strasse, D-3552 Wetter/Hessen(DE)
Patentinhaber: Degussa Aktiengesellschaft,
Weissfrauenstrasse 9, D-6000 Frankfurt am Main 1(DE)

(72) Erfinder: Schlitter, Friedrich,Wilhelm Dr., Mörikeweg 3,
D-3552 Wetter/Hessen(DE)

(74) Vertreter: Kreuzbichler, Lorenz, Dr., c/o Fa. Degussa
AG,Fachbereich Patente Postfach 1345,
D-6450 Hanau 1(DE)

# Beschreibung

Die Erfindung betrifft eine mehrlagige, starre und flexible Bereiche aufweisende Leiterplatte mit Durchkontaktierungslöchern, bestehend aus mehreren miteinander verpressten Einzellagen.

Seit einigen Jahren werden in der Elektronik-Industrie gedruckte Schaltungen eingesetzt, die starre und flexible Bereiche aufweisen. Diese Leiterplatten werden aus übereinanderliegenden starren und flexiblen Einzellagen aufgebaut, die mit Hilfe von Verbundfolien fest mitenander verklebt und verpresst sind. Es handelt sich hierbei um unbiegsame (z.B. Glas-Epoxidharz) und biegsame Isolationsträger (z.B. Polyimidfolie) mit ein oder zweiseitiger Kupferkaschierung, in die die Leiterbahnen geätzt werden. Die Form der starren Lagen legt den starren Teil der Leiterplatte fest, aus dem die flexiblen Lagen herausführen und die flexiblen Schaltungsbereiche bilden, die weitere Teile der Schaltung miteinander verbinden oder die Verbindung zu externen Baugruppen herstellen.

Die flexiblen Teile werden hergestellt, indem man in diesen Bereichen die starren Außenlagen herausbricht. Ein solches Verfahren ist z.B. in der DE-PS 2 657 212 beschrieben.

Dabei werden die zuvor mit Nuten versehenen Bereiche nach den Badbehandlungen herausgebrochen. Die Herstellung flexibler Teile wird auch in den US-PSen 4 687 695 und 3 346 415 beschrieben.

Die flexiblen Einzellagen überdecken in den bekannten Leiterplatten mit starren und flexiblen Bereichen aus Herstellungsgründen die gesamte Leiterplatte, obwohl sie eigentlich nur im flexiblen Teil benötigt werden.

Vor dem Verpresen der Einzellagen zu einer Mehrlagenschaltung (Multilayer) werden die Leiterbahnen auf den Innenlagen ätztechnisch hergestellt. Die Leiterplatten werden dann an bestimmten Stellen durchbohrt und die Löcher chemisch und galvanisch verkupfert. Dadurch erhält man eine elektrische Verbindung zwischen den Leiterbahnen auf den verschiedenen Ebenen. Außerdem dienen diese Durchkontaktierungslöcher zur Aufnahme der Anschlußbeine von Bauelementen, mit denen die Leiterplatte bestückt wird.

Da bei den bekannten Leiterplatten auch die starren Bereiche aus übereinanderliegenden starren und flexiblen Einzellagen aufgebaut sind, bestehen die Lochwandungen schichtweise aus unterschiedlichen Materialien. Vor allem werden auch Klebstoffschichten durchbohrt, wodurch der Kleber über die Lochwandungen verschmiert wird. Das Reinigen der Wandungen von dem Verkupfern ist sehr aufwendig und greift die verschiedenen Kunststoffschichten verschieden stark an, so daß Vertiefungen in den Lochwandungen entstehen. Auch das chemische Verkupfern ist aufwendig, das unterschiedliche Stoffe aktiviert und metallisiert werden müssen.

Außerdem sind die thermischen Ausdehnungskoeffizienten der flexiblen Kunststofffolien und der starren Kunststoffplatten unterschiedlich groß, so daß beim Löten der Schaltungen Spannungen und Risse auftreten können, die bis zu Delaminierungen führen.

Zur Behebung dieser Schwierigkeiten ist es beispielsweise bekannt, das Polyimid und den Kleber der flexiblen Einzellagen im Bereich der Lochwandungen mit einem Laserstrahl zu veraschen und diese Bereiche mit einem Epoxidharz auszufüllen, um ein einheitliches Material in den Lochwandungen zu erhalten. Aber auch dieses Verfahren ist sehr aufwendig und teuer.

Es war daher Aufgabe der vorliegenden Erfindung, eine mehrlagige, starre und flexible Bereiche aufweisende Leiterplatte mit Durchkontakttierungslöchern zu entwickeln, bestehend aus mehreren miteinander verpressten Einzellagen, bei der ein umständliches nachträgliches Reinigen der Lochwandungen entfällt, die Bohrlöcher dennoch einfach metallisiert werden können und zu zuverlässigen Kontakten zwischen den Leiterbahnen führen.

Diese Aufgabe wird erfindungsgemäß dadurch gelöst, daß sie abwechselnd aus starren ersten Einzel- oder Doppellagen und zweiten Einzel- oder Doppellagen aus dem gleichen nichtflexiblen (starren) Material aufgebaut ist, in die in den Bereichen, in denen die Leiterplatte flexibel sein soll, flexible kleberbeschichtete Kunststoffolien randspaltfrei, mit gleicher Dicke und mit einem etwas größeren Bereich als dem flexiblen Bereich entspricht eingelassen sind, und daß die Durchkontaktierungslöcher nur in den Bereichen der Leiterplatte eingebracht sind, die über den Querschitt gesehen überwiegend nur aus dem Material der starren Einzellagen und Kupfer bestehen.

Vorzugsweise sind die Durchkontaktierungslöcher in den Bereichen der Leiterplatte eingebracht, die ausschließlich aus dem Material der starren Einzellagen bestehen. Die eingepaßten flexiblen Kunststoffolienbereiche müssen wenige Millimeter, vorzugsweise 2 bis 10 mm, größer sein als die späteren flexiblen Bereiche, damit eine einwandfreie Verklebung der flexiblen Kunststoffolie im starren Bereich gewährleistet ist.

Die Herstellung dieser Einzellagen erfolgt in der Weise, daß man in sogenannte Prepregs, das sind Glasmatten mit nicht ausgehärtetem Expoxidharz, mit einem Werkzeug Aussparungen stanzt oder schneidet, die etwas größer sind als der gewünschte flexible Bereich der Leiterplatte. Mit dem gleichen Werkzeug werden aus einer kleberbeschichteten flexiblen Kunststoffolie komplementäre Stücke ausgeschnitten und randspaltfrei in die Prepregs eingesetzt. Dabei müssen Prepregs und Kunststoffolien so ausgewählt werden, daß die Dicke der Prepregs im verpressten Zustand gleich der Dicke der kleberbeschichteten Kunststoffolie ist. Auf die Ober- und Unterseite dieser Vorlaminate legt man dann je eine Kupferfolie und verpresst diesen Verbund bei Druck und Temperatur zu einem Laminat. In die Kupferfolien werden dann die Leitungsmuster ätztechnische eingebracht.

Vorzugsweise besteht das starre Material aus glasfaserverstärktem Epoxidharz.

Werden nun die Einzellagen zu der mehrlagigen starrflexiblen Leiterplatte zusammengeklebt – dies erfolgt mit Prepregs (Glasmatten mit nicht ausgehärtetem Epoxydharz) – so hat man im starren Bereich der Leiterplatte, in dem nacher die Bohrungen zur Durchkontaktierung eingebracht werden, einen Verbund, der nur aus Glasfasern, Epoxydharz und Cu-Folie besteht, diese Bohrungen können somit wesentlich einfacher durchkontaktiert werden als bei dem bekannten Leiterplattenaufbau. Die Kupferhülse des Bohrlochs ist zuverlässiger beim anschließenden Löten und auch später beim Einsatz der fertigen Schaltkonzeption.

Bei starr-flexiblen Leiterplatten können die flexiblen Lagen 20 und mehr Ebenen betragen. Es hat sich gezeigt, daß es hier von Vorteil für die Stabilität der Gesamtschaltung sein kann, daß ein oder zwei flexible Einzellagen den starren Bereich total bedecken. In diesem Fall ist zwar die Durchkontaktierung wie bei den zur Zeit gefertigten Leiterplatten durchzuführen. Die Qualität der Kupferhülse ist aber durch die Verminderung der flexiblen Folien und des Klebers im starren Teil zuverlässiger als bei den bekannten Leiterplatten. Letzteres tritt insbesondere bei den Schaltungen auf, die bei diskreten Verdrahtungen im starren Bereich noch eine Kleberschicht benötigen.

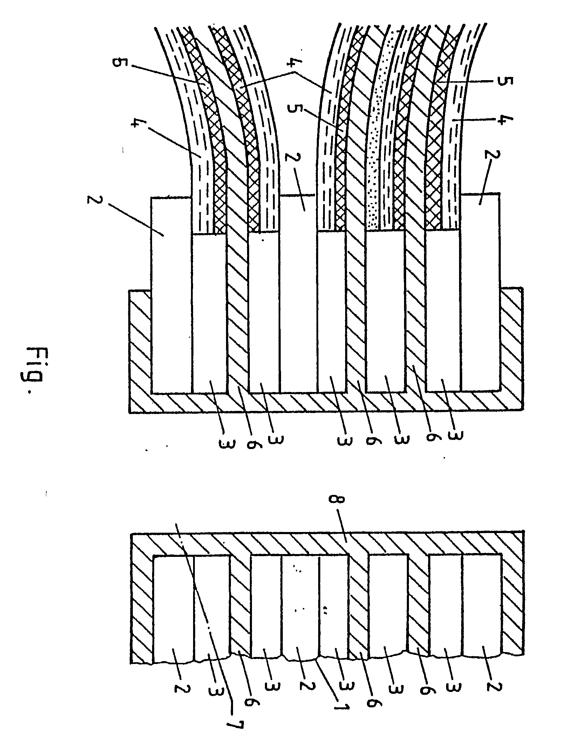

Die Abbildung zeigt schematisch ein Durchkontaktierungsloch und den Übergang starrer Bereichflexibler Bereich in einer beispielhaften Ausführungsform einer Leiterplatte im Längsschnitt.

Die Leiterplatte (1) umfasst mehrere Einzellagen (2) aus starrem Material und Einzellagen (3) aus ebenfalls starrem Material in die flexible Kunststoffolien (4) als flexible Bereiche der Leiterplatte randspaltenfrei eingelassen sind. Diese Kunststoffolien (4) sind mit einem Kleber (5) beschichtet und zusammen mit den Einzellagen (3) mit Kupferfolien (6) für die Leiterbahnen kaschiert. Im starren Bereich der Leiterplatte (1) sind die Durchkontaktierungslöcher (7) gebohrt, die mit einer Kupferschicht (8) zur Kontaktgabe metallisiert sind.

## Patentansprüche

1. Mehrlagige, starre und flexible Bereiche aufweisende Leiterplatte mit Durchkontaktierungslöchern, bestehend aus mehreren miteinander verpressten Einzellagen, dadurch gekennzeichnet, daß sie abwechselnd aus ersten Einzel- oder Doppellagen (2) und zweiten Einzel- oder Doppellagen (3) aus dem gleichen nichtflexiblen (starren) Material aufgebaut ist, in die in den Bereichen, in denen die Leiterplatte flexibel sein soll, flexible, kleberbeschichtete Kunststoffolien (4) randspaltfrei, mit gleicher Dicke und mit einem etwas größeren Bereich als dem flexiblen Bereich entspricht eingelassen sind, und daß die Durchkontaktierungslöcher (7) nur in den Bereichen der Leiterplatte (1) eingebracht sind, die über den Querschnitt gesehen überwiegend nur aus dem Material der starren Einzellagen (2, 3) und Kupfer bestehen.

2. Leiterplatte nach Anspruch 1, dadurch gekennzeichnet, daß die Durchkontaktierungslöcher (7) in den Bereichen der Leiterplatte (1) eingebracht sind, die ausschließlich aus dem Material der starren Einzellagen (2, 3) bestehen.

## Claims

1. A multilayer, locally rigid and locally flexible circuit board with through-connection holes consisting of several individual layers press-moulded with one another, characterized in that it is made up alternately of first single or double layers (2) and second single or double layers (3) of the same non-flexible (rigid) material into which flexible adhesive-coated plastic films (4) free from edge gaps, of equal thickness and with a somewhat larger area than corresponds to the flexible region are inserted in the regions in which the circuit board is intended to be flexible and in that the through-connection holes (7) are only introduced in those regions of the circuit board (1) which, over the cross-section, predominantly consist solely of the material of the rigid single layers (2, 3) and copper.

2. A circuit board as claimed in claim 1, characterized in that the through-connection holes (7) are introduced in those regions of the circuit board (1) which consist solely of the material of the rigid single layers (2, 3).

## Revendications

1. Circuit imprimé présentant des zones rigides et souples multicouches avec des trous de contact traversant, constitué de plusieurs couches individuelles pressées ensemble, caractérisé en ce qu'on le réalise en superposant alternativement une première couche simple ou double (2) et une deuxième couche simple ou double (3) du même matériau non flexible (rigide), dans lesquelles on a intercalé dans les zones où le circuit imprimé doit être souple, des films de matière plastique souple (4) enduits d'adhésif, sans jeu limitrophe, de même épaisseur et d'une étendue un peu supérieure à celle de la zone flexible, et qu'on dispose les trous de contact (7) traversants seulement dans les zones de circuit imprimé (1) qui, vues en coupe sont constitués seulement du matériau des couches individuelles (2, 3) rigides et de cuivre.

2. Circuit imprimé selon la revendication 1, caractérisé en ce qu'on implante les trous de contact traversants (7) dans les zones du circuit imprimé (1) qui sont constituées exclusivement de matériau des couches individuelles rigides (2, 3).

Fig.